# EUROPEAN PATENT APPLICATION

(11) **EP 4 343 737 A1**
(43) Date of publication of application: **27.03.2024**
(21) Application number: 22946054.8
(22) Date of filing: 10.11.2022
(51) Int. Cl.: G09F 9/00

(54) **BONDING STRUCTURE, DISPLAY PANEL, FLEXIBLE CIRCUIT BOARD, AND DISPLAY APPARATUS**

(30) Priority: 29.06.2022 CN 202210751286
(71) Applicant: Hefei Visionox Technology Co., Ltd., Hefei, Anhui 230000 (CN); Kunshan Go-Visionox Opto-Electronics Co., Ltd., KunShan, Jiangsu 215300 (CN)
(72) Inventor: XIAO, Fengjie, Hefei, Anhui 230000 (CN); ZHU, Xiujian, Hefei, Anhui 230000 (CN)
(74) Representative: Arnold & Siedsma
(86) International application number: PCT/CN2022/131090
(87) International publication number: WO 2024/000990

(57) **Abstract**

The present disclosure provides a bonding structure, a display panel, a flexible circuit board, and a display apparatus, the bonding structure includes a bonding region, the bonding region is provided with a plurality of pads, and the pads are arranged in at least one row. In a same row, pads are arranged along a first reference line, extension lines of at least two pads intersect with a second reference line perpendicular to the first reference line, an intersection point is located on a same side of the first reference line, and the second reference line is parallel to and spaced apart from a symmetric axis, perpendicular to the first reference line, of the bonding region. In the bonding structure, the pads are arranged according to a bias standard in the bonding region to improve a freedom degree of designing the pads, and there is no need to re-plan relevant traces in the bonding region or a planning degree of the traces is reduced.

## Description

### CROSS-REFERENCE TO RELATED APPLICATIONS

The present application claims priority to Chinese Patent Application No. 2022107512861, filed on June 29, 2022, which is hereby incorporated by reference in its entirety as a part of this application.

### TECHNICAL FIELD

The present disclosure relates to the field of bonding technologies, specifically to a bonding structure, a display panel, a flexible circuit board, and a display apparatus.

### BACKGROUND

In a preparation process of electronic products, circuits of some components need to be lapped, and terminals used for lapping need to be aligned with each other to ensure connection of the circuits.

In current electronic products, based on requirements of improved functionality, relative miniaturization, narrow bezel, lightening and thinning, etc., the terminals of the components for lapping external circuits need a sufficient quantity but need to occupy a small enough space, that is, a quantity of the terminals and an arrangement density of the terminals are usually relatively large, and distribution positions of the terminals in the components may be biased to reserve space for setting of a circuit structure, which makes it more difficult to lap the terminals between components, and it is easy to cause poor lapping.

### SUMMARY

In view of this, the present disclosure provides a bonding structure, arrangement of pads in this bonding structure is an asymmetric structure, so that at least in a case of a bonding region bias, impedances of the pads and connection circuits thereof may be adapted to be adjusted while avoiding other circuit structures, so as to eliminate or alleviate a problem of excessive circuit impedance fluctuation caused by the bonding region bias.

A first aspect of the present disclosure provides a bonding structure, the bonding structure includes a bonding region, where the bonding region is provided with a plurality of pads, and the pads are arranged in at least one row. Lap terminals in a same row are arranged along a first reference line, extension lines of at least two pads intersect with a second reference line perpendicular to the first reference line, and an intersection point is located on a same side of the first reference line. The second reference line is parallel to and spaced apart from a symmetric axis, perpendicular to the first reference line, of the bonding region.

In the above solution, the pads are arranged in the bonding region according to a bias standard to improve a freedom degree in designing the pads, so that impedances of the pads (which may further take into account traces connected to the pads) may be adjusted according to requirements, and there is no need to re-plan relevant traces in the bonding region or a planning degree of the traces is reduced.

In a specific embodiment of the first aspect of the present disclosure, the at least two pads having extension lines intersecting with the second reference line are located on two sides of the second reference line.

In a specific embodiment of the first aspect of the present disclosure, the bonding region is divided into a first region and a second region by the second reference line, the symmetric axis passes through the second region. In a same row, a distance, to the second reference line, from a pad located in the first region and having a largest distance to the second reference line, is less than a distance, to the second reference line, from a pad, located in the second region and having a largest distance to the second reference line. For example, further, in a same row, a quantity of pads located in the first region is less than a quantity of pads located in the second region.

In a specific embodiment of the first aspect of the present disclosure, along the first reference line, a distance, to an edge of the bonding structure that is located on a side, away from the symmetric axis, of the second reference line, from a pad located in the first region and having a largest distance to the second reference line, is greater than a distance, to an edge of the bonding structure that is located on a side, away from the second reference line, of the symmetric axis, from a pad located in the second region and having a largest distance to the second reference line.

In a specific embodiment of the first aspect of the present disclosure, in a same row, an included angle between the first reference line and an extension line of a pad located on a side, away from the symmetric axis, of the second reference line and having a largest distance to the second reference line, is greater than an included angle between the first reference line and an extension line of a pad located on a side, away from the second reference line, of the symmetric axis and having a largest distance to the second reference line. That is, in a same row, an included angle between the first reference line and an extension line of a pad located in the first region and having a largest distance to the second reference line, is greater than an included angle between the first reference line and an extension line of a pad located in the second region and having a largest distance to the second reference line.

In a specific embodiment of the first aspect of the present disclosure, in a same row, pads, having extension lines intersecting with the second reference line, have a same intersection point with the second reference line.

In another specific embodiment of the first aspect of the present disclosure, in a same row, pads, having extension lines intersecting with the second reference line, are located in the first region and the second region, respectively, extension lines of two pads with equal distances to the second reference line have a same intersection point with the second reference line, and extension lines of pads with different distances to the second reference line have different intersection points with the second reference line. Further, the greater a distance from a pad to the second reference line, the greater a distance from an intersection point of an extension line of the pad and the second reference line to the first reference line.

In another specific embodiment of the first aspect of the present disclosure, in a same row, pads, having extension lines intersecting with the second reference line, are divided into at least two groups, each one of the first region and the second region has at least one group, pads in each group are adjacent in turn, extension lines of pads in a same group have a same intersection point with the second reference line, and extension lines of pads in different groups have different intersection points with the second reference line. Further, the greater a distance from a group to the second reference line, the greater a distance from an intersection point of an extension line of a pad in the group and the second reference line to the first reference line, and/or, in two groups with equal distances to the second reference line, a distance from an intersection point of an extension line of a pad in a group located in the first region and the second reference line to the first reference line, is greater than a distance from an intersection point of an extension line of a pad in a group located in the second region and the second reference line to the first reference line.

In another specific embodiment of the first aspect of the present disclosure, in a same row, pads, having extension lines intersecting with the second reference line, are divided into at least two groups, each one of the first region and the second region has at least one group, pads in each group are adjacent in turn, extension lines of pads in a same group have different intersection points with the second reference line, and extension lines of pads in different groups have different intersection points with the second reference line. Further, in an aspect, the greater a distance from a group to the second reference line, the greater a distance from an intersection point of an extension line of a pad in the group and the second reference line to the first reference line, and/or, in another aspect, in two groups with equal distances to the second reference line, a distance from an intersection point of an extension line of a pad in a group located in the first region and the second reference line to the first reference line, is greater than a distance from an intersection point of an extension line of a pad in a group located in the second region and the second reference line to the first reference line. For example, in the another aspect, further, in a same group, the greater a distance from a pad to the second reference line, the greater a distance from an intersection point of an extension line of the pad and the second reference line to the first reference line.

In a specific embodiment of the first aspect of the present disclosure, extension lines of all pads intersect with the second reference line, and the second reference line is located in a gap of two adjacent pads.

In another specific embodiment of the first aspect of the present disclosure, extension lines of pads in a part of all pads intersect with the second reference line, and extension lines of pads in the other part are parallel to the second reference line. For example, further, the pads having extension lines parallel to the second reference line are adjacent in turn and are distributed from the first region to the second region.

In a specific embodiment of the first aspect of the present disclosure, in a same row, the greater a distance from adjacent pads to the second reference line, the smaller a gap between the adjacent pads, and/or, the greater a distance from a pad to the second reference line, the smaller a cross-sectional width of the pad at the first reference line.

In another specific embodiment of the first aspect of the present disclosure, in a same row, the greater a distance from adjacent pads to the second reference line, the greater a gap between the adjacent pads, and/or, the greater a distance from a pad to the second reference line, the greater a cross-sectional width of the pad at the first reference line.

In a specific embodiment of the first aspect of the present disclosure, a pad having an extension line intersecting with the second reference line includes a first end and a second end that are opposite, a distance from the first end to the second reference line is less than a distance from the second end to the second reference line. Along a direction parallel to the first reference line, cross-sectional widths of the first end and the second end are equal, for example, further, a plane on which a side surface, facing the second reference line, of a same pad is located, is parallel to an extension line of the same pad, and a plane on which a side surface, away from the second reference line, of the same pad is located, is parallel to an extension line of the same pad; or, along a direction parallel to the first reference line, a cross-sectional width of the first end is less than a cross-sectional width of the second end, for example, further, an intersection point of the second reference line and a plane on which a side surface, facing the second reference line, of a same pad is located, is the same as an intersection point of an extension line of the same pad and the second reference line, and an intersection point of the second reference line and a plane on which a side surface, away from the second reference line, of the same pad is located, is the same as an intersection point of an extension line of the same pad and the second reference line.

A second aspect of the present disclosure provides a display panel, the display panel includes a display region and a bonding structure in the first aspect above, where the second reference line is parallel to a direction from the bonding region to the display region. For example, further, intersection points of extension lines of pads and the second reference line are located on a side, facing the display region, of the first reference line, and/or, the display panel further includes two first driving chips located between the display region and the bonding region, the two first driving chips are electrically connected to pads, and a center of a connecting line of the two first driving chips is located on the second reference line.

A third aspect of the present disclosure provides a flexible circuit board, the flexible circuit board includes a second driving chip and a bonding structure in the first aspect above, and the second driving chip is electrically connected to a pad. For example, further, the flexible circuit board further includes a connector, the connector is electrically connected to a pad, and is located on a side, away from the symmetric axis, of the second reference line.

A fourth aspect of the present disclosure provides a display apparatus, the display apparatus includes a display panel in the second aspect above and a flexible circuit board in the third aspect above, and the display panel and the flexible circuit board are bonded together by their respective bonding structures.

### BRIEF DESCRIPTION OF THE DRAWINGS

FIG. 1 is a schematic diagram of a planar structure of a display apparatus according to an embodiment of the present disclosure.
FIG. 2 is a schematic diagram of a planar structure of the display apparatus shown in FIG. 1 in a case of additional design structures.
FIG. 3 is a cross-sectional view of the display apparatus shown in FIG. 2 along a first reference line.
FIG. 4 is a schematic diagram of a planar structure of a bonding structure of the display apparatus shown in FIG. 2.
FIG. 5 is a schematic diagram of a planar structure of a bonding structure according to another embodiment of the present disclosure.
FIG. 6A is a schematic diagram of a planar structure of a bonding structure according to another embodiment of the present disclosure.
FIG. 6B is a schematic diagram of a planar structure of a bonding structure according to another embodiment of the present disclosure.
FIG. 7A is a schematic diagram of a planar structure of a bonding structure according to another embodiment of the present disclosure.
FIG. 7B is a schematic diagram of a planar structure of a bonding structure according to another embodiment of the present disclosure.
FIG. 7C is a schematic diagram of a planar structure of a bonding structure according to another embodiment of the present disclosure.
FIG. 8 is a schematic diagram of a planar structure of a bonding structure according to another embodiment of the present disclosure.
FIG. 9A is a schematic diagram of a planar structure of a bonding structure according to another embodiment of the present disclosure.
FIG. 9B is a schematic diagram of a planar structure of a bonding structure according to another embodiment of the present disclosure.
FIG. 10 is a schematic diagram of a planar structure of a local region of a bonding structure according to another embodiment of the present disclosure.
FIG. 11 is a schematic diagram of a planar structure of a local region of a bonding structure according to another embodiment of the present disclosure.
FIG. 12 is a schematic diagram of a planar structure of a local region of a bonding structure according to another embodiment of the present disclosure.

### DETAILED DESCRIPTIONS OF THE EMBODIMENTS

Technical solutions in embodiments of the present disclosure are clearly and completely described below with reference to the accompanying drawings of the embodiments of the present disclosure. Apparently, the described embodiments are merely some but not all of the embodiments of the present disclosure. Based on the embodiments in the present disclosure, all other embodiments obtained by those of ordinary skill in the art without performing creative labor fall within a protection scope of the present disclosure.

A display apparatus includes a display panel and a flexible circuit board that are bonded together, the display panel and the flexible circuit board both include a bonding region and pads located in the bonding region, and the pads of the display panel and the pads of the flexible circuit board are docked with each other to realize electrical connection between the two. In a bonding process, a bonding region of a component that needs to be bonded is pressurized and heated by an indenter, so that the pads of the display panel and the flexible circuit board may be crimped together by a conductive adhesive. In the bonding process, the display panel and the flexible circuit board may be subjected to thermal expansion, which make widths of the pads on the display panel and the flexible circuit board and a gap between the pads increase, so that corresponding pads are deviated or misaligned, or even unable to be lapped with each other, finally leading to poor drive of the display apparatus.

In response to above problems, a size along a transverse direction (along a direction of arrangement of the pads, for example, an extension direction of a first reference line below) and an area of a pad can be increased by setting the pads to be inclined to reduce probability of poor lap between the pads. It should be noted that in this solution, since the bonding regions in the display panel and the flexible circuit board are usually located on a respective side and relatively middle position thereof, a central axis (perpendicular to an arrangement direction of the pads) of the bonding region is directly used as a reference line to design parameters such as arrangement positions and inclination degrees of inclined pads, and positions (affecting length), widths and the like of traces connected with the pads are adjusted adaptively, so as to adjust impedances of lines formed by the pads and corresponding connected traces.

However, with user's further demand for performance of the display apparatus, the display apparatus may face situations, such as, shape changes, adding an additional component and disposing a corresponding control circuit, and structural layout reconstruction, resulting in a region where the bonding region is located needs to be biased to avoid other circuit structures (such as a connector described below). In this case, different degrees of offset may be generated between each pad and a corresponding trace, that is, connection distances between some pads and the corresponding traces become smaller, and there are also connection distances between some pads and the corresponding traces become larger. If an impedance of an entire line remains unchanged (the impedance of each line is roughly unchanged, or an impedance difference between different lines is roughly unchanged), an arrangement position of an pad is still designed based on a central axis of the bonding region, and a layout and a width of a trace need to be changed, that is, the trace needs to be redesigned, which may greatly increase design and manufacturing costs of the entire display apparatus.

In view of the foregoing, an embodiment of the present disclosure provides a bonding structure, provides a display panel and a flexible circuit board that are including the bonding structure, and provides a display apparatus including the display panel and the flexible circuit board, so as to solve technical problems faced in the above situation at least. The bonding structure includes a bonding region, in which a plurality of pads are provided, and the pads are arranged in at least one row. Pads in a same row are arranged along a first reference line, extension lines of at least two pads intersect with a second reference line perpendicular to the first reference line, an intersection point is located on a same side of the first reference line, and the second reference line is parallel to and spaced apart from a symmetric axis, perpendicular to the first reference line, of the bonding region. In the bonding structure, the pads are arranged in the bonding region based on the second reference line, and the second reference line (a dummy line) is biased relative to the bonding region (its symmetric axis), which is equivalent to arranging the pads in the bonding region according to a bias standard, so as to avoid arrangements and inclination angles of pads being limited by the symmetric axis of the bonding region, thereby improving a freedom degree in designing the pads. Thus, impedances of the pads (which may further take into account traces connected to the pads) may be adjusted according to requirements, so as to eliminate or alleviate a problem of excessive impedance fluctuation in circuits involving the pads due to the bias of the bonding region, that is, there is no need to re-plan relevant traces in the bonding region or a planning degree of the traces is reduced.

In conjunction with the accompanying drawings, structures of the bonding structure, the display panel, the flexible circuit board, and the display apparatus in at least one embodiment of the present disclosure are described below. Further, since the bonding structure may be included in the display panel and the flexible circuit board, and the display apparatus includes the display panel and the flexible circuit board, therefore, in following embodiments, the structure of the display apparatus is first described to synchronously explain the structures of the bonding structure, the display panel and the flexible circuit board.

In addition, in the drawings, a space rectangular coordinate system is established based on a plane where the bonding structure (e.g., a surface carrying the pad) is located to illustrate a position of each structure in the display apparatus. In the space rectangular coordinate system, a X axis and a Y axis are parallel to the plane where the bonding structure is located, and the X axis is parallel to an arrangement direction of pads, that is, the first reference line, the Y axis is parallel to the second reference line, and a Z axis is perpendicular to the plane where the bonding structure is located.

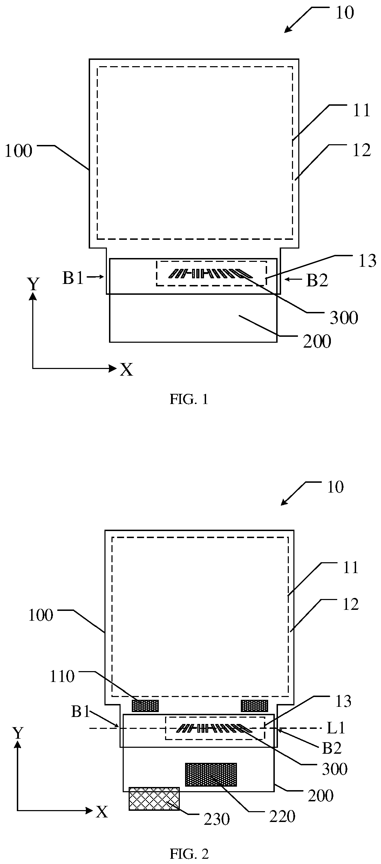

As shown in FIG. 1 - FIG. 4, a display apparatus 10 includes a display panel 100 and a flexible circuit board 200. The display panel 100 includes a substrate 101, the substrate 101 is divided into a display region 11 and a bezel region 12 (i.e., non-display region) surrounding the display region 11, a part of the substrate 101 in the bezel region 12 is used as a bearing substrate of the bonding structure, so that the bonding structure is also located in the bezel region 12. Correspondingly, a bonding region 13 of the bonding structure is also located in the bezel region 12, and the bearing substrate is used to carry pads 300 located in the bonding region 13. The flexible circuit board 200 may include a substrate 210 and a driving circuit (including a second driving chip 220) located on the substrate 210, the substrate 210 is also divided into a bonding region (not shown, coinciding with the bonding region 13 of the display panel 100) and is also provided with pads 300 of a bonding structure, and a part of the substrate 210 is used as a bearing substrate of the bonding structure for carrying the pads 300.

It should be noted that, in the embodiments of the present disclosure, a structure of the bonding structure may be designed based on specific structural requirements of the display panel and the flexible circuit board. Therefore, before introducing specific design of the bonding structures in the display panel and flexible circuit board, specific structures of the display panel and flexible circuit board are explained as follows.

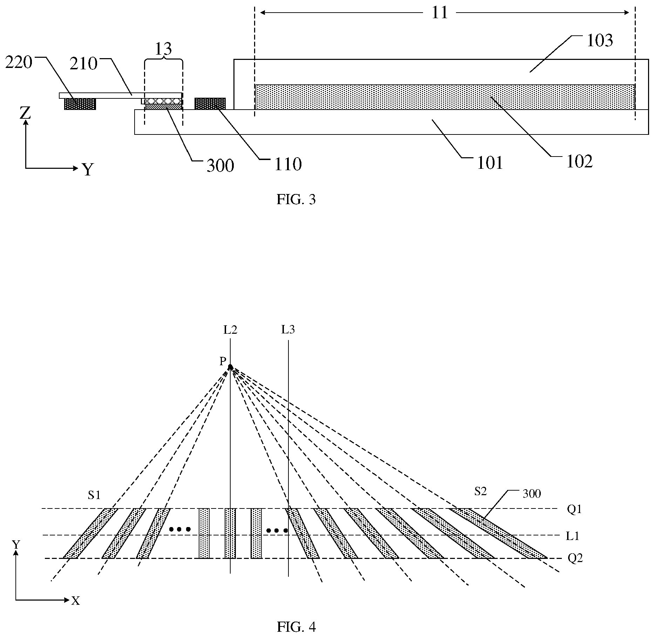

As shown in FIG. 2 and FIG. 3, the display panel 100 may include a substrate 101 and a display function layer 102 located on the substrate 101. For example, the display function layer 102 includes light-emitting devices arranged in arrays, the light-emitting devices are used to constitute subpixels of the display panel. For example, the substrate 101 may be an array substrate, which includes a basement and a driving circuit layer, and the driving circuit layer may include a pixel driving circuit. In subpixels corresponding to each light-emitting device, the pixel driving circuit may include a plurality of transistors, capacitors, etc., for example, formed as 2T1C (i.e., 2 transistors (T) and 1 capacitor (C)), 3T1C or 7T1C and the like. The pixel driving circuit is connected to the light-emitting device to control a switching state and luminous brightness of the light-emitting device. The substrate 101 may be provided with signal lines (not shown in figures) for controlling the pixel driving circuit, the signal lines extend to the bonding region 13 and are connected to the pads 300 of the display panel 100, so that after the pads 300 of the display panel 100 and the pads 300 of the flex circuit board 200 are connected, the driving circuit (e.g., a second driving chip 210) on the flexible circuit board 200 is connected to these signal lines to control the pixel driving circuit. In the embodiments of the present disclosure, there is no restriction on a type of signal lines, the signal lines may be one or a combination of a gate line, a data line, a common electrode line, a power line, a ground line, a frame starting scan line and a reset line, etc. For example, the display panel may further include an encapsulation layer 103 covering the display function layer 102.

It should be noted that, in a case that the display panel is a flexible panel (such as an Organic Light-Emitting Diode (OLED) panel), a part of the display panel located in the bezel region can be bent to a back (a side that deviates from the display side), so as to achieve narrow bezel display or bezel-less display, so that for users, the entire bezel region is visually invisible. For example, a portion of the bonding structure (including the bonding region 13) in FIG. 1 - FIG. 3, may be bent to the back of the display region, in this case, the flexible circuit board 200 and a second driving chip 220 on it are also located on the back of the display panel 100.

For the display panel, with improvement of functions and complexity of a structure, it is necessary to set up a plurality of driving chips to control functions of the display panel. In this case, a portion of the signal lines in the display panel 100 are connected to a first driving chip 110, and the other portion of the signal lines are connected to the pads 300 to be further connected to a second driving chip 220 on the flexible circuit board 200; alternatively, a portion of the signal lines are connected to the first driving chip 110, and then connected to the pads 300, and further connected to the second driving chip 220 on the flexible circuit board 200.

For example, the display panel may also include a touch structure, so the display panel needs driving chips for display function and touch function separately. In this case, as shown in FIG. 2 and FIG. 3, one of the first driving chip 110 and the second driving chip 220 is a driving chip for display function, and the other one is a touch chip.

In the display panel, as shown in FIG. 1 ~FIG. 4, the two driving chips 110 located on the display panel 100 are located between the display region 11 and the bonding region 13, and the two first driving chips 110 are spaced apart to reserve space for signal lines to the bonding region 13, so that the two first driving chips 110 may be evenly arranged on two sides of the signal lines.

In absence of a design solution for pads in the embodiments of the present disclosure, because arrangement of signal lines before extending to the bonding region 13 is set symmetrically with respect to a symmetry axis (roughly parallel to a direction from the display region to the bonding region) of the display region, the pads connected to the signal lines also need to be arranged symmetrically relative to the symmetric axis in order to facilitate planning an impedance of a structure composed of the pads and the corresponding connected signal lines. Thus, when designing an inclined pad, the symmetric axis is also be used as a reference to design a position and an inclination degree of the pad. For example, by designing a position of an intersection point of an extension line of the pad and the symmetric axis to adjust spacings and inclination angles of different pads (e.g., an included angle between the extension line of the pad and the symmetric axis or an angle complementary to the included angle), so that the pads are also roughly symmetrically arranged relative to the symmetric axis. It should be noted that in this case, a symmetric axis in the bonding region has coincided with the symmetric axis in the display region, that is, the symmetric axis of the display region is used as a reference to design the positions and the inclination degrees of the pads, and in practice, the symmetric axis of the bonding region is used as a reference to design the positions and the inclination degrees of the pads.

As shown in FIG. 2 ~FIG. 4, in a case that the bonding region 13 is required to be biased due to some process requirements of the display panel 100, the bonding region 13 (or its symmetric axis) of the display panel 100 is offset relative to the symmetric axis of the display region, that is, the pads are also offset from original positions. If the pads are still designed based on the symmetric axis of the bonding region 13, then a layout of original signal lines need to be changed, which may cause impedances of these signal lines to change, thereby affecting the function of the display panel.

For example, as shown in FIG. 2, a connector 230 may be provided on the flexible circuit board 200, and some of the pads 300 need to be connected to the connector 230 via traces, so that the flexible circuit board 200 needs to reserve space for these traces, and the bonding region on the flexible circuit board 200 needs to be biased to avoid the traces. Correspondingly, the bonding region 13 on the display panel 100 also needs to be biased (the symmetric axis of the bonding region 13 is offset relative to the symmetric axis of the above display region). In this case, if design is based on the symmetric axis of the bonding region 13, the degrees of offset, between different pads and corresponding signal lines, are different. For example, for a pad with a larger offset, a signal line connected to it can shorten a distance corresponding to the pad, that is, an overall length of the signal line is reduced, which may lead to excessive difference in impedances of structures composed of different pads and corresponding signal lines. Without readjusting a width of the signal line to adjust its impedance, it is impossible to eliminate the problem of excessive impedance difference by systematically planning (macroscopic arrangement rules have high design efficiency) the impedances of the pads.

It should be noted that in the embodiments of the present disclosure, a specific type of the connector is not limited, and can be designed according to an actual process and functional requirements of the display panel. For example, the connector may be a connection device electrically connected to an external circuit (such as a motherboard) so that the display panel is used to receive signals from the external circuit.

In the bonding structure provided by at least one embodiment of the present disclosure, as shown in FIG. 1 - FIG. 4, in the pads 300 arranged in a row in the bonding region, the pads 300 is arranged along the first reference line L1, the first reference line L1 and the second reference line L2 are perpendicular, the second reference line L2 is parallel to and spaced from the symmetric axis L3 of the bonding region 13, and a direction from the second reference line L2 to the symmetric axis L3 is an offset direction (biased direction) of the bonding region 13. In the bonding region 13, some pads 300 are set to be inclined, extension lines of the inclined pads 300 intersect with the second reference line L2 at an intersection point P. Thus, on a side, facing the axis symmetric L3, of the second reference line L2 (right side in FIG. 4), the pad 300 may be macroscopically designed to have a relatively larger inclination degree. As a distance to the second reference line L2 is increased, the inclination degree is greater (the included angle between the extension line and the second reference line L2 is larger), and thus the pad 300 has a larger size in an extension direction of the first reference line L1, a degree of compensating its offset is greater, thereby reducing an impedance difference degree in the structures composed of different pads 300 and their corresponding signal lines.

In this design, based on the second reference line L2, the pads 300 are arranged in the bonding region 13. In fact, it is equivalent to arranging the pads 300 in the bonding region 13 in a biased manner to match a bias situation of the bonding region, so as to adapt to adjust the impedances of the pads (which may further take into account the signal lines connected to the pads), thereby eliminating or alleviating the problem of excessive impedance fluctuation in circuits involving the pads due to the bias of the bonding region. That is, there is no need to re-plan (for example, to increase or decrease a design width of the traces) relevant traces in the bonding region or to a planning degree of the traces is reduced.

In the embodiments of the present disclosure, as shown in FIG. 4, at least two pads 300 having extension lines intersecting with the second reference line L2 are located on two sides of the second reference line L2. In a case that the second reference line L2 is biased relative to the symmetric axis L3, a quantity of the pads 300 on one side of the second reference line L2 and a quantity of the pads 300 on the other side of the second reference line L2 are unequal. Specifically, the bonding region is divided into a first region S1 and a second region S2 by the second reference line L2, and the symmetric axis L3 passes through the second region S2. In a same row, a distance, to the second reference line L2, from a pad 300 located in the first region S1 and having a largest distance to the second reference line L2, is less than a distance, to the second reference line L2, from a pad 300, located in the second region S2 and having a largest distance to the second reference line L2. In this embodiment, compared with a pad 300 located in the first region S1 and located at an end of the bonding region, a pad 300 located in the second region S2 and located at an end of the bonding region is farther away from the second reference line L2. Thus, in a case that the pads 300 of the first region S1 and the second region S2 have an approximately same arrangement density, a quantity of pads 300 located in the first region S1 is less than a quantity of pads 300 located in the second region S2.

In an embodiment of the present disclosure, exemplarily, as shown in FIG. 1 ~ FIG. 4, along the first reference line L1, the bonding structure includes an edge B1 and an edge B2 located at two ends, respectively. In a case that the bonding region 13 is offset from the edge B 1 to the edge B2, the edge B1 is located on a side, away from the symmetric axis L3, of the second reference line L2, and the edge B2 is located on a side, away from the second reference line L2, of the symmetric axis L3. A distance, from a pad located in the first region S1 and having a largest distance to the second reference line L2, to the edge B1 of the bonding structure, is greater than a distance, from a pad located in the second region S2 and having a largest distance to the second reference line L2, to the edge B2 of the bonding structure. In this embodiment, with respect to a pad located in the second region S2 and located at an end of the bonding region 13, a pad located in the first region S1 and located at an end of the bonding region 13 is farther from the edge of the bonding structure.

In an embodiment of the present disclosure, exemplarily, as shown in FIG. 4, in a same row, an included angle between an extension line of a pad located in the first region S1 and having a largest distance to the second reference line L2 and the first reference line L1, is greater than an included angle between an extension line of a pad located in the second region S2 and having a largest distance to the second reference line L2 and the first reference line L1. In this embodiment, with respect to a pad located in the first region and located at an end of the bonding region, a pad located in the second region and located at an end of the bonding region has a greater inclination degree, so that under a same condition (e.g., a same design width), a pad located in the second region and located at an end of the bonding region may have a greater impedance relative to a pad located in the first region and located at an end of the bonding region.

It should be noted that in the embodiments of the present disclosure, under a premise that a reference line used for arranging the pads is biased relative to the symmetric axis of the bonding region, all the pads may be arranged by taking each pad as the smallest unit, or the pads may be grouped, and all pads are arranged by taking the group as the smallest unit. In the following, several arrangements of the pads are explained by several specific embodiments.

In some embodiments of the present disclosure, as shown in FIG. 4, in a same row, the pads 300, having extension lines intersecting with the second reference line L2, have a same intersection point with the second reference line L2, that is, extension lines of all pads 300 set to be inclined intersect with the second reference line L2 at a same intersection point P. Under this condition, all the inclined pads 300 may satisfy a rule that the farther away from the second reference line L2, the greater the inclination degree, and thus the greater the length along the extension line, so as to adjust the impedances of the pads 300. In addition, the pads 300 are arranged based on a same intersection point P, which is convenient for layout design under a condition that the above rule is met.

In other embodiments of the present disclosure, in a same row, pads, having extension lines intersecting with the second reference line, are located in the first region and the second region, respectively, extension lines of two pads with equal distances to the second reference line have a same intersection point with the second reference line, and extension lines of pads with different distances to the second reference line have different intersection points with the second reference line. Thus, a part of the pads are symmetrical with respect to the second reference line, extension lines of two symmetrical pads and the second reference line intersect at a same point, and extension lines of asymmetrical pads have different intersection points with respect to the second reference line.

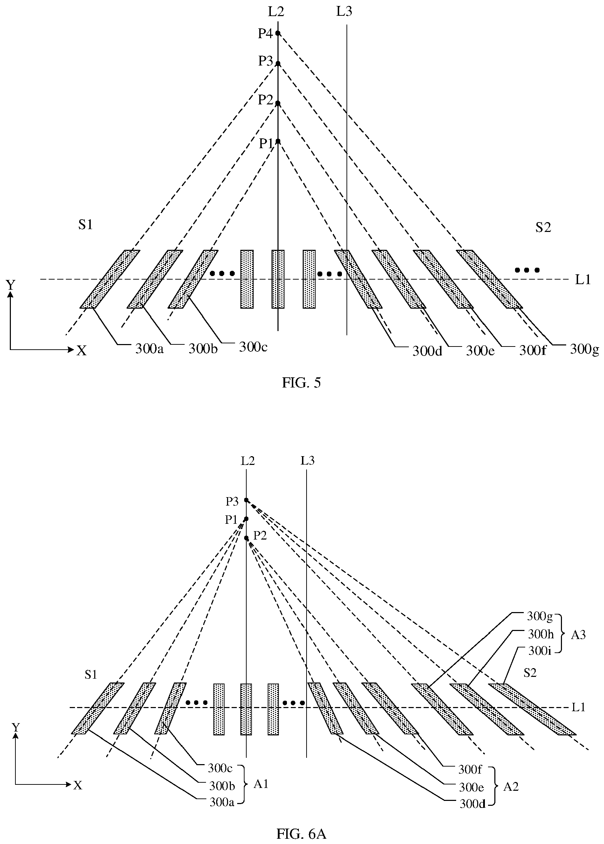

Exemplarily, as shown in FIG. 5, seven inclined pads 300a -- 300g are arranged along the first reference line L1, the pad 300a and the pad 300f, the pad 300b and the pad 300e, the pad 300c and the pad 300d are symmetrical with respect to the second reference line L2, respectively, and the pad 300g is not symmetrical with other pads. An extension line of the pad 300a and an extension line of the pad 300f intersect with the second reference line L2 at a same intersection point P3, an extension line of the pad 300b and an extension line of the pad 300e intersect with the second reference line L2 at a same intersection point P2, an extension line of the pad 300c and an extension line of the pad 300d intersect with the second reference line L2 at a same intersection point P1, and an extension line of the pad 300g intersect with the second reference line L2 at an intersection point P4. In the above solution, spacings between the various intersection points can be adjusted to control an inclination degree of each two symmetrical pads, so that this solution has a higher freedom degree in adjusting the impedances of the pads than the solution shown in FIG. 4.

For example, in a case that extension lines of each two symmetrical pads intersect with the second reference line at a same point, and extension lines of asymmetrical pads intersect with the second reference line at different points, the greater the distance from a pad to the second reference line, the greater the distance from an intersection point of an extension line of the pad and the second reference line to the first reference line. For example, as shown in Figure 5, the pads P1~P4 are located on a same side of the first reference line L1, and distances from the pads P1~P4 to the first reference line L1 increase sequentially. Under this condition, the inclined pads are set to have a same inclination degree, that is, located on either one of the first region S1 and the second region S2, extension lines of the pads are parallel to each other. Alternatively, the greater the distance from a pad to the second reference line L2, the greater the inclination degree of the pad, that is, the greater the distance from a pad to the second reference line L2, the greater the included angle (acute angle) between an extension line of the pad and the second reference line L2.

It should be noted that in the embodiments of the present disclosure, the "equal" with respect to distance may be roughly equal within a certain range (negligible difference in macroscopic terms) of distance difference. For example, the "distance" may be the minimum distance from a centroid of the pad to the second reference line.

In other embodiments of the present disclosure, in a same row, in each first region and each second region, inclined adjacent pads are grouped to avoid connection of arrangement regularity of the pads located in the two regions, so that the arrangement of the pads has a greater freedom degree. In addition, by planning the arrangement of pads in a form of grouping, difficulty of layout design can still be reduced. For example, pads, having extension lines intersecting with the second reference line, are divided into at least two groups, each one of the first region and the second region has at least one group, pads in each group are adjacent in turn, extension lines of pads in a same group have a same intersection point with the second reference line, and extension lines of pads in different groups have different intersection points with the second reference line. Exemplarily, as shown in FIG. 6A, nine inclined pads 300a-300g are arranged along the first reference line L1, three adjacent pads 300a--300c located in the first region S1 are the first group, and extension lines of the three pads intersect with the second reference line L2 at a same intersection point P1; three adjacent pads 300d--300f located in the second region S2 are the second group, and extension lines of the three pads intersect with the second reference line L2 at a same intersection point P2; and three adjacent pads 300g--300i located in the second region S2 are the third group, and extension lines of the three pads intersect with the second reference line L2 at a same intersection point P3. The three intersection points P1, P2 and P3 are spaced apart from each other.

For example, in each first region and each second region, when inclined adjacent pads are grouped and pads of a same group intersect with the second reference line at a same intersection point, an arrangement order and spacing of intersection points can be adjusted according to actual process needs to regulate a structure of pads of each group.

In a specific example, the greater the distance from a group to the second reference line, the greater the distance from an intersection point of an extension line of a pad in the group and the second reference line to the first reference line. As shown in FIG. 6A, in the second region S2, a distance from the intersection point P3 of pads in the third group A3 and the second reference line L2 to the first reference line L1, is greater than a distance from the intersection point P2 of pads in the second group A2 and the second reference line L2 to the first reference line L1. Further, in two groups with equal distances to the second reference line, a distance from an intersection point of an extension line of a pad in a group located in the first region and the second reference line to the first reference line, is greater than a distance from an intersection point of an extension line of a pad in a group located in the second region and the second reference line to the first reference line. Exemplarily, as shown in FIG. 6A, a distance from an integral composition of the pads in the first group A1 to the second reference line and a distance from an integral composition of the pads in the second group A2 to the second reference line are approximately equal. A distance from the intersection point P1 of the pads in the first group A1 in the first region S 1 and the second reference line L2 to the first reference line L1, is greater than a distance from the intersection point P2 of the pads in the second group A2 and the second reference line L2 to the first reference line L1. In this solution, pads in the second region may have a greater inclination degree relative to pads in the first region, so that they can be adjusted to have larger impedances, which is more suitable for a regulation of line impedances in a case of bias of the bonding region.

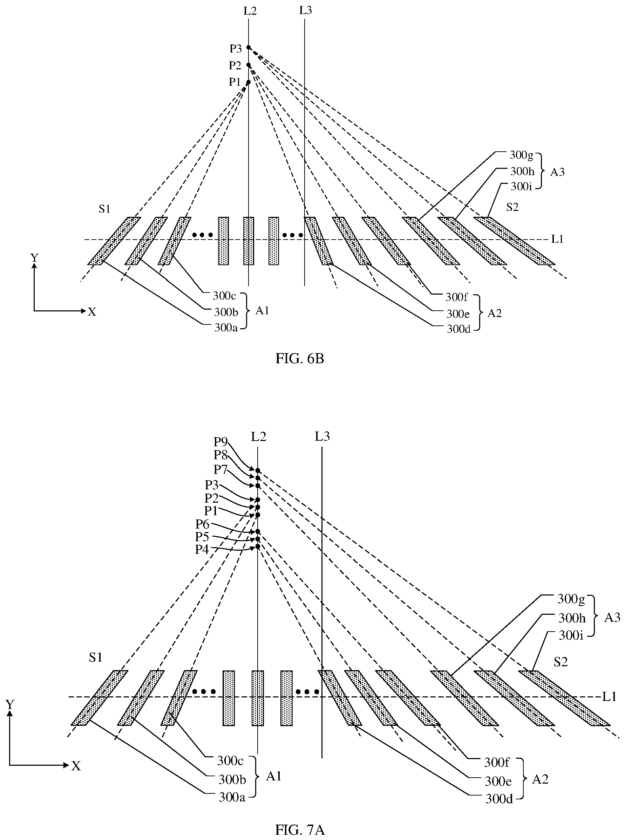

In another specific example, the greater the distance from a group to the second reference line, the greater the distance from an intersection point of an extension line of a pad in the group and the second reference line to the first reference line. As shown in FIG. 6B, in the second region S2, a distance from the intersection point P3 of pads in the third group A3 and the second reference line L2 to the first reference line L1, is greater than a distance from the intersection point P2 of the pads in the second group A2 and the second reference line L2 to the first reference line L1. Further, in two groups with equal distances to the second reference line, a distance from an intersection point of an extension line of a pad in a group located in the first region and the second reference line to the first reference line, is less than a distance from an intersection point of an extension line of a pad in a group located in the second region and the second reference line to the first reference line. Exemplarily, as shown in FIG. 6B, a distance from an integral composition of the pads in the first group A1 to the second reference line and a distance from an integral composition of the pads in the second group A2 to the second reference line are approximately equal. A distance from the intersection point P1 of the pads in the first group A1 in the first region S 1 and the second reference line L2 to the first reference line L1, is less than a distance from the intersection point P2 of the pads in the second group A2 and the second reference line L2 to the first reference line L1.

In other embodiments of the present disclosure, in a same row, in each first region and each second region, inclined adjacent pads are grouped to avoid connection of arrangement regularity of the pads located in the two regions, and inclination degrees of the pads in each group are further adjusted, so that the arrangement of the pads has a greater freedom degree. In addition, by planning the arrangement of pads in a form of grouping, difficulty of layout design can still be reduced. For example, pads, having extension lines intersecting with the second reference line, are divided into at least two groups, each one of the first region and the second region has at least one group, pads in each group are adjacent in turn, extension lines of pads in a same group have different intersection points with the second reference line, and extension lines of pads in different groups have different intersection points with the second reference line. Exemplarily, as shown in FIG. 7A, nine inclined pads 300a-300g are arranged along the first reference line L1, three adjacent pads 300a-300c located in the first region S1 are the first group, and extension lines of the three pads intersect with the second reference line L2 at intersection points P1-P3, respectively; three adjacent pads 300d--300f located in the second region S2 are the second group, and extension lines of the three pads intersect with the second reference line L2 at intersection points P4-P6, respectively; and three adjacent pads 300g--300i located in the second region S2 are the third group, and extension lines of the three pads intersect with the second reference line L2 at intersection points P7-P9, respectively. The nine intersection points P1~P9 are spaced apart from each other, the intersection points P1~P3 are adjacent, the intersection points P4~P6 are adjacent, and the intersection points P7~P9 are adjacent.

For example, in each first region and each second region, when inclined adjacent pads are grouped and pads of a same group intersect with the second reference line at different intersection points, an arrangement order and spacings of intersection points can be adjusted according to actual process needs, so as to further regulate a structure of pads of each group.

In a specific example, the greater the distance from a group to the second reference line, the greater the distance from an intersection point of an extension line of a pad in the group and the second reference line to the first reference line. As shown in FIG. 7A, in the second region S2, a distance from any one of intersection points P7 -- P9 of pads in the third group A3 and the second reference line L2 to the first reference line L1, is greater than a distance from any one of intersection points P4 -- P6 of pads in the second group A2 and the second reference line L2 to the first reference line L1. For example, in two groups with equal distances to the second reference line, a distance from an intersection point of an extension line of a pad in a group located in the first region and the second reference line to the first reference line, is greater than a distance from an intersection point of an extension line of a pad in a group located in the second region and the second reference line to the first reference line. Exemplarily, as shown in FIG. 7A, a distance from an integral composition of the pads in the first group A1 to the second reference line L2 and a distance from an integral composition of the pads in the second group A2 to the second reference line L2 are approximately equal. A distance from any one of intersection points P1~P3 of pads in the first group A1 in the first region S1 and the second reference line L2 to the first reference line L1, is greater than a distance from any one of intersection point P4~P6 of pads in the second group A2 and the second reference line L2 to the first reference line L1. For example, further, in a same group, the greater the distance from a pad to the second reference line, the greater the distance from an intersection point of an extension line of the pad and the second reference line to the first reference line. Exemplarily, as shown in FIG. 7A, intersection points P1 -- P9 are located on a same side of the first reference line L1, and distances from the intersection points P4, P5, P6, P1, P2, P3, P7, P8, P9 to the first reference line L1 increase in turn.

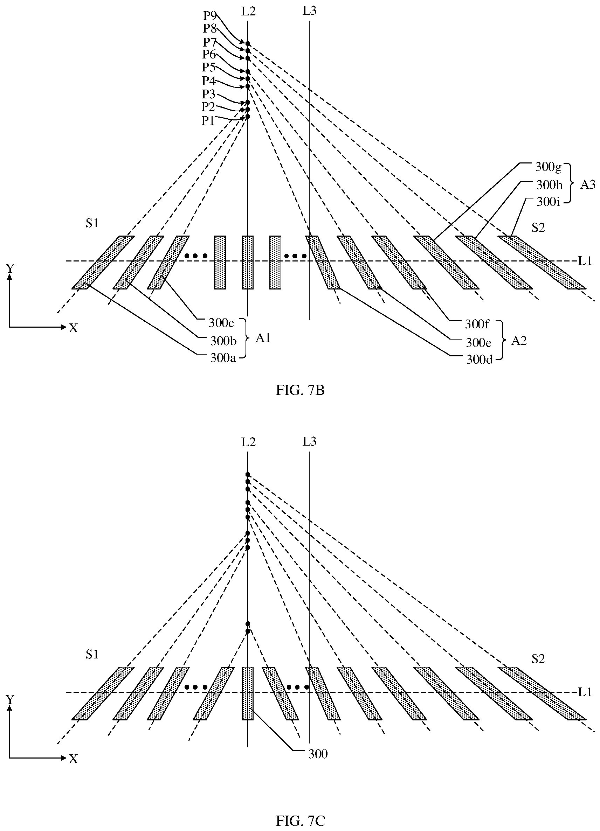

In another specific example, the greater the distance from a group to the second reference line, the greater the distance from an intersection point of an extension line of a pad in the group and the second reference line to the first reference line. As shown in FIG. 7B, in the second region S2, a distance from any one of intersection points P7 -- P9 of the pads in the third group A3 and the second reference line L2 to the first reference line L1, is greater than a distance from any one of the intersection points P4 -- P6 of the pads in the second group A2 and the second reference line L2 to the first reference line L1. For example, in two groups with equal distances to the second reference line, a distance from an intersection point of an extension line of a pad in a group located in the first region and the second reference line to the first reference line, is less than a distance from an intersection point of an extension line of a pad in a group located in the second region and the second reference line to the first reference line. Exemplarily, as shown in FIG. 7A, a distance from an integral composition of the pads in the first group A1 to the second reference line L2 and a distance from an integral composition of the pads in the second group A2 to the second reference line L2 are approximately equal. A distance from any one of intersection points P1~P3 of pads in the first group A1 in the first region S 1 and the second reference line L2 to the first reference line L1, is less than a distance from any one of intersection point P4~P6 of pads in the second group A2 and the second reference line L2 to the first reference line L1. For example, further, in a same group, the greater the distance from a pad to the second reference line, the greater the distance from an intersection point of an extension line of the pad and the second reference line to the first reference line. Exemplarily, as shown in FIG. 7B, intersection points P1 -- P9 are located on a same side of the first reference line L1, and distances from the intersection points P1 ~ P9 to the first reference line L1 increase in turn.

It should be noted that in the embodiments of the present disclosure, a proportion of a quantity of inclined pads is not limited, and can be designed according to needs of an actual process.

In some embodiments of the present disclosure, as shown in FIG. 7B, extension lines of pads 300a -- 300i in a part of all pads intersect with the second reference line L1, and extension lines of pads in the other part (e.g., the pads located between groups A1 and A2) are parallel to the second reference line L2. Pads with extension direction parallel to the second reference line L2 can be set to one or more according to actual needs.

For example, as shown in FIG. 7B, the pads (set as vertical pads) having extension lines parallel to the second reference line are set to be multiple and adjacent in turn, and are distributed from the first region S1 to the second region S2, that is, the second reference line L2 passes through a region where vertical pads are located. For example, in a case that a quantity of the vertical pads is even, the second reference line L2 may be further designed to pass through a gap between two adjacent vertical pads. For example, in a case that a quantity of the vertical pads is odd (e.g., three vertical pads as shown in FIG. 7C), the second reference line L2 may be further designed to pass through the most middle vertical pad.

For example, as shown in FIG. 7C, the pad 300 (set as a vertical pad) having an extension line parallel to the second reference line is set to one, and the second reference line L2 passes through a region where the vertical pad 300 is located.

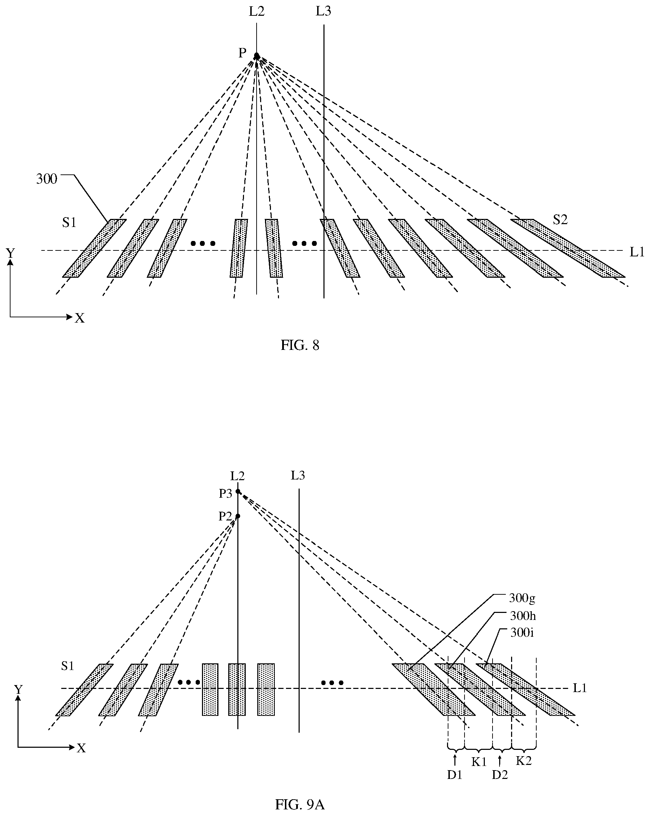

For example, in other embodiments of the present disclosure, as shown in FIG. 8, all pads 300 are tilted, that is, extension lines of all the pads 300 intersect with the second reference line. For example, the second reference line L2 is located in a gap of two adjacent pads 300.

It should be noted that in the embodiments of the present disclosure, widths and gap sizes of the pads are not limited, and can be designed according to needs of an actual process. The following describes several design options for the widths and gaps of the pads.

For example, in some embodiments of the present disclosure, in a same row, the greater a distance from adjacent pads to the second reference line, the smaller a gap between the adjacent pads. Exemplarily, as shown in FIG. 9A, in the second region S2, pads 300g -- 300i are adjacent in turn and distances from pads 300g -- 300i to the second reference line L2 increase sequentially, and a gap width D1 between the pad 300g and the pad 300h is greater than a gap width D2 between the pad 300h and the pad 300i. For example, the greater a distance from a pad to the second reference line, the smaller a cross-sectional width of the pad at the first reference line. Exemplarily, as shown in FIG. 9A, a cross-sectional width K1 of the pad 300h is greater than a cross-sectional width K2 of the pad 300i. In this solution, the farther away from the second reference line L2, the smaller a width of a pad, resulting in a greater impedance, which is more suitable for regulating line impedances in a case of bias of the bonding region.

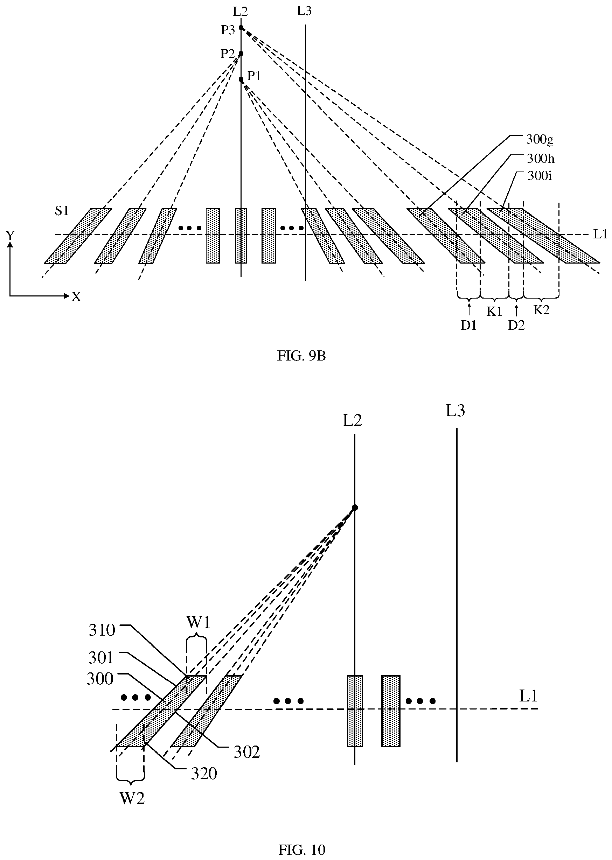

For example, in some other embodiments of the present disclosure, in a same row, the greater a distance from adjacent pads to the second reference line, the greater a gap between the adjacent pads. Exemplarily, as shown in FIG. 9B, in the second region S2, pads 300g -- 300i are adjacent in turn and distances from the pads 300g -- 300i to the second reference line L2 increase sequentially, and a gap width D1 between the pad 300g and the pad 300h is less than a gap width D2 between the pad 300h and the pad 300i. For example, the greater a distance from a pad to the second reference line, the greater a cross-sectional width of the pad at the first reference line. Exemplarily, as shown in FIG. 9B, a cross-sectional width K1 of the pad 300h is less than a cross-sectional width K2 of the pad 300i. In a bonding process of the bonding structure, the pads may be offset due to thermal expansion, and the greater a distance from a pad to the second reference line, the greater an offset of the pad. A design of the above solution may ensure that the pads of two bonding structure can be lapped and have a relatively high lap area, while reducing a risk of misaligned lap.

In an embodiment of the present disclosure, shapes of side surfaces of pads may be designed according to an actual process to further adjust widths of the pads and spacing changes between adjacent pads in a direction along the first reference line. In the following, through several specific embodiments, several shape designs of the pads are described.

For example, in some embodiments of the present disclosure, a pad having an extension line intersecting with the second reference line includes a first end and a second end that are opposite, and a distance from the first end to the second reference line, is less than a distance from the second end to the second reference line. Along a direction parallel to the first reference line, cross-sectional widths of the first end and the second end are equal. Further, for example, a plane on which a side surface, facing the second reference line, of a same pad is located, is parallel to an extension line of the same pad, and a plane on which a side surface, away from the second reference line, of the same pad is located, is parallel to an extension line of the same pad. In these embodiments, plane shapes of the pads are parallelograms, for details, referring to shapes of the pads shown in FIG. 9B.

For example, in other embodiments of the present disclosure, edges of an inclined pad may be designed to converge towards an intersection point to reduce a risk of misaligned lap of the pad. Exemplarily, as shown in FIG. 10, a pad 300 having an extension line intersecting with the second reference line includes a first end 310 and a second end 320 that are opposite, a distance from the first end 310 to the second reference line L2 is less than a distance from the second end 320 to the second reference line L2, and thus the first end 310 is oriented towards the intersection point with respect to the second end 320. Along a direction parallel to the first reference line L1, a cross-sectional width of the first end 310 is less than a cross-sectional width of the second end L2. For example, further, as shown in FIG. 10, an intersection point of the second reference line L2 and a plane on which a side surface, facing the second reference line, of a same pad 300 is located, is also an intersection point of an extension line (passing through a centroid of the pad 300) of the same pad 300 and the second reference line L2; and an intersection point of the second reference line L2 and a plane on which a side surface, away from the second reference line, of the same pad 300 is located, is also an intersection point of an extension line (passing through a centroid of the pad 300) of the same pad 300 and the second reference line L2.

It should be noted that in at least embodiments shown in FIGS. 9B and 10, when describing a shape of a side surface of a pad, the "a plane on which a side surface, is located" may be a plane where a surface determined at an edge of the first end and an edge of the second end in the side surface, is located, and the shape of the side surface may be designed to be planar, stepped, concave-convex (wavy), arc-shaped (circular arc or elliptical arc, etc.), etc. according to actual process requirements.

In the embodiments of the present disclosure, a specific shape of a pad is not limited, and can be designed according to actual process situations. For example, on a basis of the design of the shape of a side surface of a pad as described above, shapes of surfaces, facing and away from the substrate, of the pad, and a length of the pad can be designed according to actual process requirements to determine a specific shape of the pad. In the following, through several specific embodiments, several shape designs of the pad are described.

For example, in some embodiments of the present disclosure, referring to FIG. 4 again, a plane where surfaces, facing an intersection point P, of the pads 300 are located, is a plane Q1, a plane where surfaces, away from the intersection point P, of the pads 300 are located, is a plane Q2, and the plane Q1 and plane Q2 are parallel to the first reference line L1. In this case, shapes of inclined pads 300 are not designed to be rectangular, and designed to be as parallelograms, and under limitation of the plane Q1 and the plane Q2, the greater the inclination degree of a pad 300, the larger the length of the pad 300.

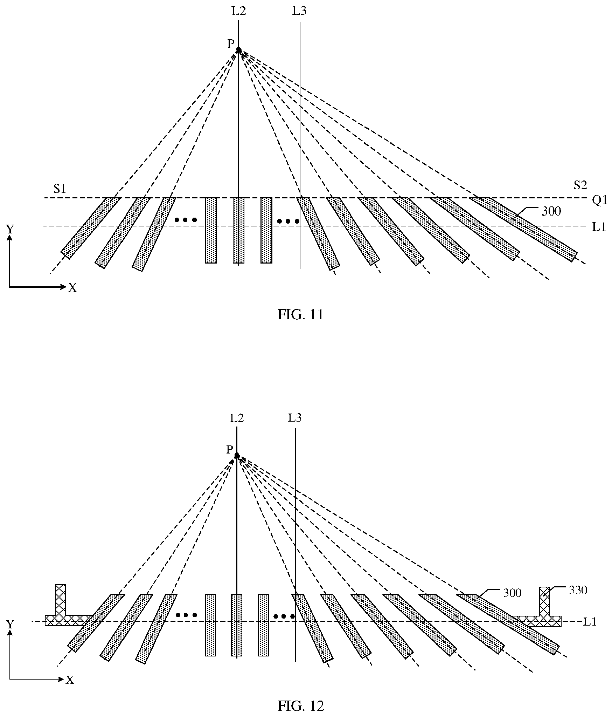

For example, in other embodiments of the present disclosure, as shown in FIG. 11, a plane where surfaces, facing an intersection point P, of the pads 300 are located, is a plane Q1, the plane Q1 is parallel to the first reference line L1, and ends, away from the intersection point P, of a plurality of pads 300 designed as inclined, are not located in a same straight line, that is, ends, away from the intersection point P, of the pads 300 designed as inclined, are not flush. In this case, if two side surfaces of each pad are parallel to each other (for example, in a case shown in FIG. 9B), a surface, away from the intersection point P, of the pad 300 may be designed to be perpendicular to the two side surfaces, so that a plane shape of the pad 300 may be a right-angle trapezoid. In these embodiments, a length of each pad 300 can be freely adjusted, so as to further improve the freedom degree when designing impedances of the pads 300.

It should be noted that shapes of the pads in an embodiment shown in FIG. 11 may be modified according to needs of an actual process, for example, ends, facing the intersection point P, of the pads 300, may also be designed to be not in a same straight line (equivalent to not in a same plane). Further, side surfaces of each pad are not limited to being designed to be parallel to each other (as shown in FIG. 10). In addition, even in a case that two side surfaces of each pad are parallel to each other (such as in a case of FIG. 9B), a surface, away from the intersection point P, of the pad 300 may be designed to intersect but not perpendicular to the two side surfaces.

In the embodiments of the present disclosure, an alignment structure may also be designed in the bonding region to improve an alignment accuracy of the two bonding structures during a lapping process. Exemplarily, as shown in FIG. 12, a counterpoint structure 330 is disposed on a side, away from the second reference line L2, of each of the two pads 300 farthest from the second reference line L2.

The foregoing are only better embodiments of the present application and are not intended to limit the present application, and any modification, equivalent substitution, etc. made within a spirit and principles of the present application shall be included in a protection scope of the present application.

## Claims

1. A bonding structure, comprising a bonding region, wherein the bonding region is provided with a plurality of pads, the pads are arranged in at least one row,
pads in a same row are arranged along a first reference line, extension lines of at least two pads intersect with a second reference line perpendicular to the first reference line, an intersection point is located on a same side of the first reference line, and the second reference line is parallel to and spaced apart from a symmetric axis, perpendicular to the first reference line, of the bonding region; and
an included angle between the first reference line and an extension line of a pad located on a side, away from the symmetric axis, of the second reference line and having a largest distance to the second reference line, is greater than an included angle between the first reference line and an extension line of a pad located on a side, away from the second reference line, of the symmetric axis and having a largest distance to the second reference line.

2. The bonding structure according to claim 1, wherein the at least two pads having extension lines intersecting with the second reference line are located on two sides of the second reference line.

3. The bonding structure according to claim 2, wherein the bonding region is divided into a first region and a second region by the second reference line, the symmetric axis passes through the second region, and
in a same row, a distance, to the second reference line, from a pad located in the first region and having a largest distance to the second reference line, is less than a distance, to the second reference line, from a pad, located in the second region and having a largest distance to the second reference line.

4. The bonding structure according to claim 3, wherein in a same row, a quantity of pads located in the first region is less than a quantity of pads located in the second region.

5. The bonding structure according to claim 3 or 4, wherein along the first reference line, a distance, to an edge of the bonding structure that is located on a side, away from the symmetric axis, of the second reference line, from a pad located in the first region and having a largest distance to the second reference line, is greater than a distance, to an edge of the bonding structure that is located on a side, away from the second reference line, of the symmetric axis, from a pad located in the second region and having a largest distance to the second reference line.

6. The bonding structure according to any one of claims 2-5, wherein in a same row, pads, having extension lines intersecting with the second reference line, have a same intersection point with the second reference line; or
pads, having extension lines intersecting with the second reference line, are located in the first region and the second region, respectively, and extension lines of two pads with equal distances to the second reference line have a same intersection point with the second reference line, extension lines of pads with different distances to the second reference line have different intersection points with the second reference line, and the greater a distance from a pad to the second reference line, the greater a distance from an intersection point of an extension line of the pad and the second reference line to the first reference line.

7. The bonding structure according to any one of claims 2-5, wherein in a same row, pads, having extension lines intersecting with the second reference line, are divided into at least two groups, each one of the first region and the second region has at least one group, pads in each group are adjacent in turn, extension lines of pads in a same group have a same intersection point with the second reference line, and extension lines of pads in different groups have different intersection points with the second reference line.

8. The bonding structure according to claim 7, wherein in a same row, the greater a distance from a group to the second reference line, the greater a distance from an intersection point of an extension line of a pad in the group and the second reference line to the first reference line, and/or, in two groups with equal distances to the second reference line, a distance from an intersection point of an extension line of a pad in a group located in the first region and the second reference line to the first reference line, is greater than a distance from an intersection point of an extension line of a pad in a group located in the second region and the second reference line to the first reference line.

9. The bonding structure according to any one of claims 2-5, wherein in a same row, pads, having extension lines intersecting with the second reference line, are divided into at least two groups, each one of the first region and the second region has at least one group, pads in each group are adjacent in turn, extension lines of pads in a same group have different intersection points with the second reference line, and extension lines of pads in different groups have different intersection points with the second reference line.

10. The bonding structure according to claim 9, wherein in a same row, the greater a distance from a group to the second reference line, the greater a distance from an intersection point of an extension line of a pad in the group and the second reference line to the first reference line, and/or, in two groups with equal distances to the second reference line, a distance from an intersection point of an extension line of a pad in a group located in the first region and the second reference line to the first reference line, is greater than a distance from an intersection point of an extension line of a pad in a group located in the second region and the second reference line to the first reference line, and
in a same group, the greater a distance from a pad to the second reference line, the greater a distance from an intersection point of an extension line of the pad and the second reference line to the first reference line.

11. The bonding structure according to any one of claims 5-10, wherein extension lines of all pads intersect with the second reference line, and the second reference line is located in a gap of two adjacent pads; or
extension lines of pads in a part of all pads intersect with the second reference line, and extension lines of pads in the other part are parallel to the second reference line, a quantity of pads having extension lines parallel to the second reference line are at least two, and the pads having extension lines parallel to the second reference line are adjacent in turn and are distributed from the first region to the second region; or
an extension line of one pad is parallel to the second reference line, extension lines of the other pads intersect with the second reference line, and the second reference line passes through the pad having an extension line parallel to the second reference line.

12. The bonding structure according to any one of claims 2-11, wherein in a same row,
the greater a distance from adjacent pads to the second reference line, the smaller a gap between the adjacent pads, and/or, the greater a distance from a pad to the second reference line, the smaller a cross-sectional width of the pad at the first reference line.

13. The bonding structure according to any one of claims 2-11, wherein in a same row,
the greater a distance from adjacent pads to the second reference line, the greater a gap between the adjacent pads, and/or, the greater a distance from a pad to the second reference line, the greater a cross-sectional width of the pad at the first reference line.

14. The bonding structure according to any one of claims 2-11, wherein a pad having an extension line intersecting with the second reference line comprises a first end and a second end that are opposite, a distance from the first end to the second reference line is less than a distance from the second end to the second reference line, and
along a direction parallel to the first reference line, cross-sectional widths of the first end and the second end are equal, a plane on which a side surface, facing the second reference line, of a same pad is located, is parallel to an extension line of the same pad, and a plane on which a side surface, away from the second reference line, of the same pad is located, is parallel to an extension line of the same pad; or
along a direction parallel to the first reference line, a cross-sectional width of the first end is less than a cross-sectional width of the second end, an intersection point of the second reference line and a plane on which a side surface, facing the second reference line, of a same pad is located, is the same as an intersection point of an extension line of the same pad and the second reference line, and an intersection point of the second reference line and a plane on which a side surface, away from the second reference line, of the same pad is located, is the same as an intersection point of an extension line of the same pad and the second reference line.

15. A display panel, comprising a display region and a bonding structure according to any one of claims 1-14, wherein the second reference line is parallel to a direction from the bonding region to the display region.

16. The flexible circuit board according to claim 15, wherein intersection points of extension lines of pads and the second reference line are located on a side, facing the display region, of the first reference line.

17. The flexible circuit board according to claim 15 or 16, wherein the display panel further comprises two first driving chips located between the display region and the bonding region, the two first driving chips are electrically connected to pads, and a center of a connecting line of the two first driving chips is located on the second reference line.

18. A flexible circuit board, comprising a second driving chip and a bonding structure according to any one of claims 1-14, wherein the second driving chip is electrically connected to a pad.

19. The flexible circuit board according to claim 18, comprising a connector, wherein the connector is electrically connected to a pad, and is located on a side, away from the symmetric axis, of the second reference line.

20. A display apparatus, comprising a display panel according to any one of claims 15-17 and a flexible circuit board according to claim 18 or 19, wherein the display panel and the flexible circuit board are connected by bonding structures.
